# EUROPÄISCHE PATENTSCHRIFT

(11) **EP 1 163 677 B1**
(45) Veröffentlichungstag und Bekanntmachung des Hinweises auf die Patenterteilung: **18.12.2002**
(21) Anmeldenummer: 00918693.3
(22) Anmeldetag: 10.03.2000
(51) Int. Cl.: G11C 11/22, G11C 7/14

(54) **INTEGRIERTER SPEICHER MIT SPEICHERZELLEN UND REFERENZZELLEN UND ENTSPRECHENDES BETRIEBSVERFAHREN**
INTEGRATED MEMORY WITH MEMORY CELLS AND REFERENCE CELLS AND CORRESPONDING OPERATING METHOD
MEMOIRE INTEGREE A CELLULES DE MEMOIRE ET A CELLULES DE REFERENCE ET PROCEDE DE FONCTIONNEMENT DE LADITE MEMOIRE

(30) Priorität: 23.03.1999 DE 19913109
(43) Veröffentlichungstag der Anmeldung: 19.12.2001
(73) Patentinhaber: Infineon Technologies AG, 81669 München (DE)
(72) Erfinder: BÖHM, Thomas, D-85604 Zorneding (DE); BRAUN, Georg, D-80339 München (DE); MANYOKI, Zoltan, Kanata, Ontario K2L 3W9 (CA); RÖHR, Thomas, D-85609 Aschheim (DE); HOENIGSCHMID, Heinz, East Fishkill, NY 12524 (US)
(74) Vertreter: Epping Hermann & Fischer
(86) Internationale Anmeldenummer: DE0000758
(87) Internationale Veröffentlichungsnummer: WO00057424

(56) Entgegenhaltungen:
- EP-A- 0 049 630
- EP-A- 0 365 002

## Beschreibung

Die Erfindung betrifft einen integrierten Speicher mit Speicherzellen und Referenzzellen und ein Betriebsverfahren für einen solchen Speicher.

Derartige Speicher sind beispielsweise in der US-A 5,572,459 und in der US-A 5,844,832 beschrieben. Die dort beschriebenen Speicher sind vom Typ FRAM. Dies sind ferroelektrische Speicher, die ähnlich wie DRAMs (Dynamic Random Access Memory) aufgebaut sind, deren Speicherkondensator jedoch ein ferroelektrisches Dielektrikum aufweist. Jeweils einem Bitleitungspaar ist ein differentieller Leseverstärker zugeordnet. Ein Lesezugriff erfolgt gleichzeitig auf je eine Speicherzelle zweier Bitleitungspaare. Auf der jeweils anderen Bitleitung jedes Bitleitungspaares wird ein Referenzpotential erzeugt, das zwischen zwei Versorgungspotentialen des Speichers liegt. Jeder Leseverstärker verstärkt das an seinen Anschlüssen anliegende Differenzsignal und damit die aus den Speicherzellen ausgelesenen Daten.

Die Erzeugung des Referenzpotentials erfolgt auf folgende Weise: Zunächst wird auf derjenigen Bitleitung jedes Bitleitungspaares, die nicht mit der gerade auszulesenden Speicherzelle verbunden ist, der Inhalt einer Referenzzelle ausgelesen. Dabei ist in der Referenzzelle des einen Bitleitungspaares ein hoher logischer Pegel und in der Referenzzelle des anderen Bitleitungspaares ein niedriger logischer Pegel gespeichert. Anschließend werden die beiden Bitleitungen, auf die der Inhalt der Referenzzellen ausgelesen wurde, miteinander kurzgeschlossen. Auf diese Weise stellt sich auf diesen beiden Bitleitungen ein Referenzpotential ein, das in etwa dem Mittelwert der beiden zuvor auf ihnen erzeugten Potentiale entspricht.

Zur Erzeugung des Referenzpotentials ist es also wichtig, daß in den beiden Referenzzellen zuvor jeweils unterschiedliche Potentiale gespeichert werden. Zu diesem Zweck sehen die beide US-Patentschriften spezielle Einrichtungen vor, die das Einschreiben der unterschiedlichen Potentiale in die Referenzzellen bewirken.

Der Erfindung liegt die Aufgabe zugrunde, einen integrierten Speicher der beschrieben Art anzugeben, bei dem die Erzeugung zweier unterschiedlicher Potentiale in Referenzzellen zweier Bitleitungspaare unter Ausnutzung bereits vorhandener Komponenten erfolgt.

Diese Aufgabe wird mit einem integrierten Speicher gemäß Patentanspruch 1 gelöst. Patentanspruch 5 betrifft ein vorteilhaftes Betriebsverfahren für einen derartigen Speicher.

Der erfindungsgemäße Speicher weist Wortleitungen, wenigstens vier Referenzwortleitungen und zwei Paare von Bitleitungen auf. Weiterhin weist er Speicherzellen auf, die in Kreuzungspunkten jeder Wortleitung mit je einer Bitleitung jedes Bitleitungspaares angeordnet sind. Ferner weist er Referenzzellen auf, die in Kreuzungspunkten jeder Referenzwortleitung mit einer der Bitleitungen angeordnet sind. Zwei differentielle Leseverstärker sind mit je einem der Bitleitungspaare verbunden. Der Speicher weist zwei erste Schaltelemente auf, die jeweils eine Bitleitung des ersten Paares mit einer Bitleitung des zweiten Paares verbinden sowie zwei zweite Schaltelemente, die jeweils eine der Referenzzellen des einen Bitleitungspaares mit derjenigen Bitleitung des anderen Paares verbinden, die nicht über das entsprechende erste Schaltelement mit der dieser Referenzzelle zugeordneten Bitleitung verbunden ist.

Dabei dienen die ersten Schaltelemente einem Kurzschließen der mit ihnen verbundenen Bitleitungen, um ein für die Bewertung eines Differenzsignals durch die Leseverstärker benötigtes Referenzpotential auf die anhand der US-A 5,572,459 und der US-A 5,844,832 weiter oben beschriebene Art zu erzeugen. Die zweiten Schaltelemente dienen dazu, nach einer durch die Leseverstärker durchgeführten Bewertung beziehungsweise nach einem Verstärken des an ihnen anliegenden Differenzsignals wieder geeignete Potentiale in die Referenzzellen zurückzuschreiben. Die zweiten Schaltelemente ermöglichen es, dieses Rückschreiben mittels der ohnehin vorhandenen Leseverstärker durchzuführen.

Die Erfindung eignet sich daher vorzugsweise zum Einsatz in integrierten Speichern mit Referenzzellen, deren Inhalt beim Auslesen zerstört wird und der deshalb nach dem Auslesen wieder hergestellt werden muß. Derartige Speicher sind beispielsweise DRAMs und FRAMs. Mittels der zweiten Schaltelemente ist es möglich, bei diesem Rückschreiben beide zuvor ausgelesenen Referenzzellen mit demselben Leseverstärker zu verbinden. Da jeder aktivierte Leseverstärker an seinen Anschlüssen zueinander komplementäre Potentiale erzeugt, ist hierdurch gewährleistet, daß in die beiden Referenzzellen zueinander komplementäre Potentiale eingeschrieben werden.

Würde man ohne Vorhandensein der zweiten Schaltelemente ein Rückschreiben von Potentialen in die Referenzzellen durch die Leseverstärker vorsehen, wären diese Potentiale abhängig von dem zuvor vom Leseverstärker ausgelesenen Datum der normalen Speicherzelle. Daher wäre es dann möglich, daß in beide Referenzzellen, für die ein gemeinsames Kurzschlußelement in Form des ersten Schaltelementes vorgesehen ist, das gleiche Potential eingeschrieben wird. Dies ist jedoch nicht zulässig, da in diese beiden Referenzzellen für die Erzeugung des gewünschten Referenzpotentials, wie zuvor erläutert, unterschiedliche Potentiale eingeschrieben werden müssen.

Indem für das Einschreiben von Informationen in die Referenzzellen aufgrund des Vorhandenseins der zweiten Schaltelemente die Leseverstärker verwendet werden können, werden die beiden unterschiedlichen Potentiale (logisch "1" und logisch "0") den Referenzzellen auf dieselbe Art zugeführt, wie entsprechende einzuschreibende Daten den normalen Speicherzellen zugeführt werden. Da in beiden Fällen die einzuschreibende Information vom Leseverstärker geliefert wird, erfolgt die beschriebene Erzeugung des Referenzpotentials in einer Weise, die an den Schreibvorgang in die normalen Speicherzellen angepaßt ist.

Gemäß dem erfindungsgemäßen Betriebsverfahren erfolgt bei einem Lesezugriff ein gleichzeitiges Auslesen je einer normalen Speicherzelle auf jedem Bitleitungspaar. Anschließend wird über eines der zweiten Schaltelemente bewirkt, daß die zuvor ausgelesenen beiden Referenzzellen mit dem gleichen Leseverstärker verbunden werden. Dann erfolgt ein gleichzeitiges Rückschreiben des von diesem Leseverstärker verstärkten Differenzsignals in eine der ausgelesenen Speicherzellen und in die beiden mit ihm verbundenen ausgelesene Referenzzelle und ein Rückschreiben des von dem anderen Leseverstärker verstärkten Referenzsignals in die andere ausgelesene Speicherzelle. Das Rückschreiben in die Speicherzellen und Referehzzellen erfolgt aufgrund der Gleichzeitigkeit vorteilhafterweise relativ schnell.

Die Erfindung wird im folgenden anhand der Figuren näher erläutert, die Ausführungsbeispiele der Erfindung zeigen. Es zeigen:
- Figur 1: ein erstes Ausführungsbeispiel des erfindungsgemäßen integrierten Speichers,
- Figur 2: ein zweites Ausführungsbeispiel und
- Figur 3: ein Ausführungsbeispiel einer Speicherzelle beziehungsweise einer Referenzzelle der in den Figuren 1 und 2 dargestellten Speicher.

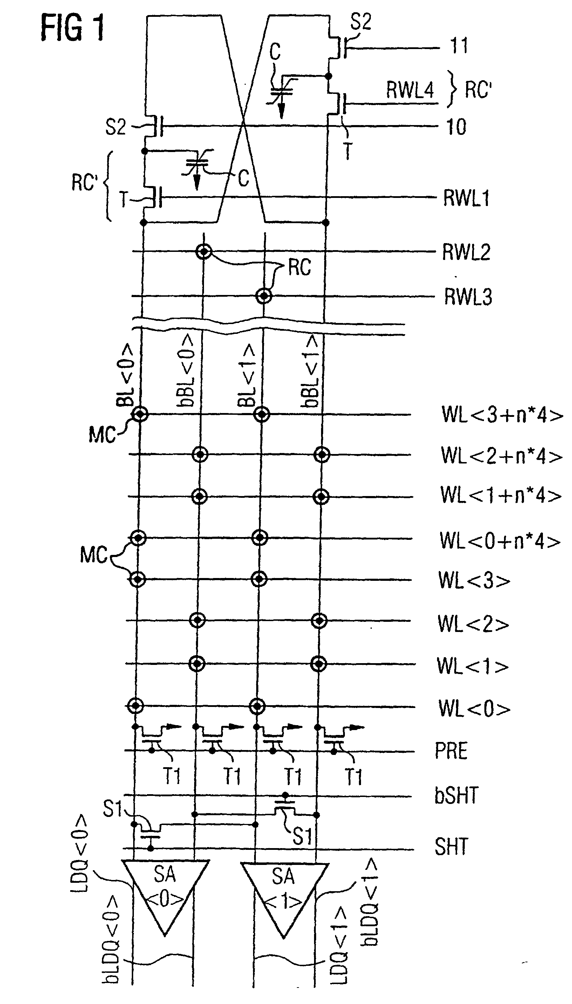

Figur 1 zeigt einen erfindungsgemäßen integrierten Speicher in Form eines FRAMs. Dieser weist Bitleitungen BLi, bBli, Wortleitungen WLi und Referenzwortleitungen RWLi auf. Weiterhin weist er Speicherzellen MC auf, die in Kreuzungspunkten der Bitleitungen mit den Wortleitungen WLi angeordnet sind. Er weist auch Referenzzellen RC auf, die in Kreuzungspunkten der Bitleitungen mit den Referenzwortleitungen RWLi angeordnet sind. Von den zahlreichen Bitleitungen BLi, bBLi des Speichers sind in Figur 1 nur zwei Bitleitungspaare dargestellt. Jedem Bitleitungspaar ist ein Leseverstärker SAi zugeordnet, der zum Verstärken eines auf dem jeweiligen Bitleitungspaar anliegenden Differenzsignals dient und dieses verstärkt auf Datenleitungen LDQi, bLDQi weitergibt. Jede Bitleitung ist über einen Transistor T1 mit einem festen Potential verbunden, das einem Vorladen der Bitleitungen bei einem durchzuführenden Lesezugriff auf eine der Speicherzellen dient. Steueranschlüsse der Transistoren T1 sind mit einer Vorladeleitung PRE verbunden.

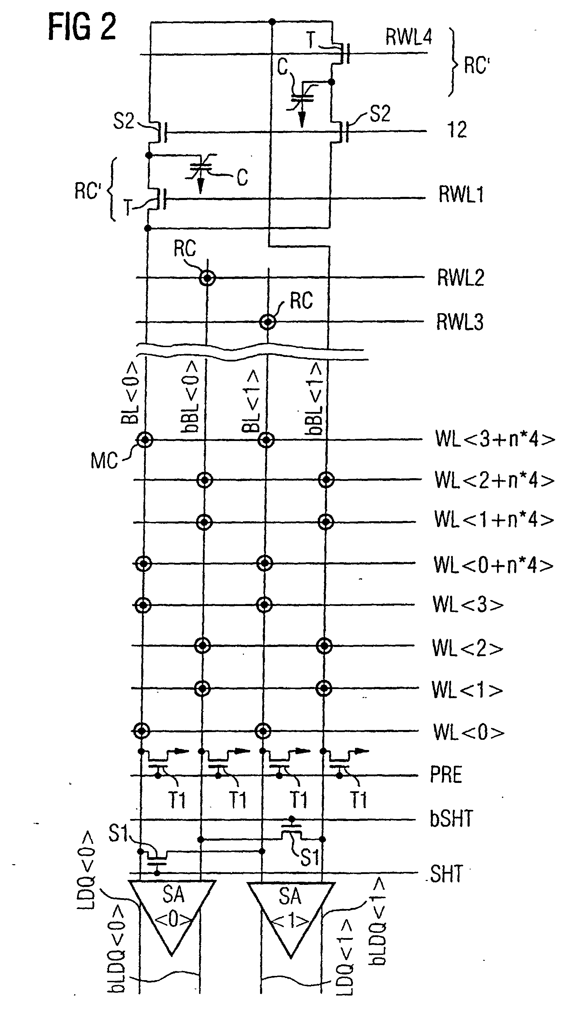

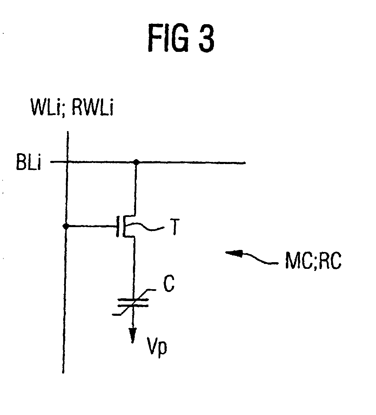

In den Figuren 1 und 2 sind die Speicherzellen MC und zwei der Referenzzellen RC nur symbolisch durch Kreise angedeutet, während zwei andere der Referenzzellen RC' in den Figuren vollständig dargestellt wurden. Die nur symbolisch eingetragenen Speicherzellen MC und Referenzzellen RC haben jeweils den in Figur 3 dargestellten Aufbau. Es handelt sich um Speicherzellen vom 1-Transistor-1-Kondensator-Typ, die jeweils einen Auswahltransistor T und einen Speicherkondensator C mit ferroelektrischem Dielektrikum aufweisen. Der Auswahltransistor T verbindet eine Elektrode des Speicherkondensators C mit einer der Bitleitungen BLi, während ein Steueranschluß des Auswahltransistors T mit einer der Wortleitungen WLi beziehungsweise Referenzwortleitungen RWLi verbunden ist. Die zweite Elektrode des Speicherkondensators ist mit einem Plattenpotential V_{P} verbunden.

Die beiden im oberen Bereich der Figur 1 explizit dargestellten Referenzzellen RC' sind genauso wie die Speicherzellen MC und die anderen Referenzzellen RC aufgebaut. Sie weisen also ebenfalls einen Auswahltransistor T und einen Speicherkondensator C der anhand Figur 3 soeben erläuterten Art auf. Die Referenzzellen RC' unterscheiden sich jedoch von den anderen Zellen MC, RC, indem die mit dem jeweiligen Auswahltransistor T verbundene Elektrode des Speicherkondensators C über jeweils ein zweites Schaltelement S2 mit einer der Bitleitungen des jeweils anderen Bitleitungspaares verbunden ist.

Ein Steueranschluß des in Figur 1 linken zweiten Schaltelementes S2 ist mit einer ersten Steuerleitung 10 und ein Steueranschluß des rechten zweiten Schaltelementes S2 mit einer zweiten Steuerleitung 11 verbunden.

Der in Figur 1 dargestellte Speicher weist weiterhin zwei erste Schaltelemente S1 auf, über die jeweils eine Bitleitung der beiden Bitleitungspaare miteinander verbunden sind. Die ersten Schaltelemente S1 dienen, wie im folgenden noch erläutert wird, einem Kurzschließen der mit ihnen verbundenen Bitleitungen zur Erzeugung eines Referenzpotentials.

Das linke erste Schaltelement S1 in Figur 1 ist an seinem Steueranschluß mit einer ersten Kurzschlußleitung SHT verbunden, und das rechte erste Schaltelement S1 mit einer zweiten Kurzschlußleitung bSHT.

In Figur 1 ist - von links nach rechts zählend - die erste Bitleitung BL0 mit der dritten Bitleitung BL1 und die zweite Bitleitung bBL0 mit der vierten Bitleitung bBL1 über je eines der ersten Schaltelemente S1 verbunden. Die der ersten Bitleitung BL0 zugeordnete Referenzzelle RC' ist über ihr zweites Schaltelement S2 mit der vierten Bitleitung bBL1 verbunden. Die mit der vierten Bitleitung bBL1 über ihren Auswahltransistor T verbundene Referenzzelle RC' ist über ihr zweites Schaltelement S2 mit der ersten Bitleitung BL0 verbunden.

Die zweiten Schaltelemente S2 verbinden also jeweils die ihnen zugeordnete Referenzzelle RC' mit derjenigen Bitleitung des jeweils anderen Bitleitungspaares, mit der die dieser Referenzzelle RC' zugeordnete Bitleitung nicht gleichzeitig auch über eines der ersten Schaltelemente S1 verbunden ist.

Die ersten und zweiten Schaltelemente S1, S2 sowie die Transistoren T1 sowie die Auswahltransistoren T sind bei dem hier betrachteten Ausführungsbeispielen n-Kanal-Transistoren.

Obwohl bei den hier erläuterten Ausführungsbeispielen die Bitleitungspaare nach dem "Folded-Bitline-Konzept" angeordnet sind, das eine besonders einfache Anordnung der zweiten Schaltelemente S2 ermöglicht, sind andere Ausführungsbeispiele möglich, bei denen die Bitleitungspaare nach dem "Open-Bitline-Konzept" angeordnet sind.

Im folgenden wird ein Lesezugriff auf den in Figur 1 dargestellten Speicher erläutert; Zunächst werden die vier Bitleitungen auf das feste Potential vorgeladen, indem die Vorladeleitung PRE die Transistoren T1 kurzzeitig leitend schaltet. Anschließend wird über einen (nicht dargestellten) Wortleitungsdecoder eine der Wortleitungen WLi auf einen hohen Pegel gebracht, während die übrigen Wortleitungen auf einem niedrigen Pegel bleiben. Beispielsweise wird die Wortleitung WL0 aktiviert. Hierdurch wird der Auswahltransistor T der beiden mit dieser Wortleitung WL0 verbundenen Speicherzellen MC geöffnet und verbindet somit leitend den zugehörigen Speicherkondensator C mit der jeweiligen Bitleitung BL0, BL1. Gleichzeitig wird über die zweite Referenzwortleitung RWL2 und die vierte Referenzwortleitung RWL4 jeweils diejenige Referenzzelle RC, RC' selektiert, die mit einer der beiden anderen Bitleitungen bBL0, bBL1 verbunden ist. Hierdurch wird aus diesen beiden Referenzzellen die darin gespeicherte Information auf die beiden Bitleitungen bBL0 und bBL1 ausgelesen. Hierbei wird vorausgesetzt, daß in diesen beiden auszulesenden Referenzzellen entgegengesetzte logische Zustände (logisch "0" und logisch "1") gespeichert sind. Diese Informationen sind in die Referenzzellen entweder bei einer Initialisierung des Speichers oder am Ende eines bereits zuvor durchgeführten Lesezugriffs auf die Speicherzellen MC auf die weiter unten noch genauer erläuterte Weise über die Leseverstärker SAi eingeschrieben worden.

Die beiden mit den auszulesenden Referenzzellen RC, RC' verbundenen Bitleitungen bBLi, die nach dem Auslesen unterschiedliche Potentiale aufweisen, werden nun über das zwischen ihnen angeordnete erste Schaltelement S1 kurzgeschlossen, indem die zweite Kurzschlußleitung bSHT vorübergehend einen hohen Pegel annimmt. Die erste Kurzschlußleitung SHT behält bei einem Zugriff auf Speicherzellen MC, die mit den Bitleitungen BL0 und BL1 verbunden sind, fortwährend einen niedrigen Pegel. Die beiden über das rechte erste Schaltelement S1 kurzgeschlossenen Bitleitungen bBLi nehmen durch Ladungsausgleich ein Potential an, das ungefähr dem arithmetischen Mittelwert der beiden Potentiale entspricht, die sie zuvor aufwiesen. Dieser Mittelwert ist das für eine ordnungsgemäße Funktion der Leseverstärker benötigte Referenzpotential. Nun wird das erste Schaltelement S1 über die zweite Kurzschlußleitung bSTH wieder gesperrt. Anschließend erfolgt eine Aktivierung der beiden Leseverstärker SAi, die daraufhin die auf dem mit ihnen verbundenen Bitleitungspaar befindlichen Differenzsignale verstärken und an die Datenleitungen LDQi, bLDQi weitergeben. Dabei liegt vor der Aktivierung der Leseverstärker an jeweils einem Eingang der Leseverstärker das zuvor erzeugte Referenzpotential an. Die Leseverstärker SAi verstärken die anliegenden Differenzsignale auf volle Versorgungspegel.

Da es sich bei FRAMs um Speicher handelt, bei denen der Speicherzelleninhalt bei einem Lesezugriff zerstört wird, muß die aus den Speicherzellen MC ausgelesene Information wieder in diese zurückgeschrieben werden. Außerdem muß auch die aus den Referenzzellen RC, RC' ausgelesene Information wieder hergestellt werden. Zu diesem Zweck wird am Ende des Lesezugriffs auf die beiden mit der Wortleitung WL0 verbundenen Speicherzellen MC die zweite Referenzwortleitung RWL2 auf einem hohen Potential gelassen, während die vierte Referenzwortleitung RWL4 auf niedriges Potential gebracht wird. Gleichzeitig wird die zweite Steuerleitung 11 auf ein hohes Potential gebracht (die erste Referenzwortleitung RWL1, die dritte Referenzwortleitung RWL3 und die erste Steuerleitung 10 bleiben bei diesem Lesezugriff fortwährend auf niedrigem Pegel). Auf diese Weise wird die in Figur 1 rechts dargestellte Referenzzelle RC' von der vierten Bitleitung bBL1 elektrisch getrennt und mit der ersten Bitleitung BL0 elektrisch verbunden.

Da auch die Wortleitung WL0 noch einen hohen Pegel aufweist, ist der linke Anschluß des ersten Leseverstärkers SA0 nun gleichzeitig elektrisch mit der soeben ausgelesenen Speicherzelle MC und mit der rechten Referenzzelle RC' verbunden. Der rechte Anschluß des Leseverstärkers SA0 ist elektrisch leitend mit der mit der zweiten Referenzwortleitung RWL2 verbundenen Referenzzelle RC verbunden. Der linke Anschluß des zweiten Leseverstärkers SA1 ist elektrisch leitend mit der anderen soeben ausgelesenen Speicherzelle MC verbunden, während der rechte Anschluß des zweiten Leseverstärkers SA1 mit keiner der Speicherzellen MC oder Referenzzellen RC, RC' elektrisch leitend verbunden ist. Somit erfolgt ein Rückschreiben der soeben aus den Speicherzellen MC ausgelesenen und durch die Leseverstärker SAi verstärkten Informationen beziehungsweise Differenzsignale gleichzeitig in beide während dieses Lesezugriffs ausgelesenen Speicherzellen MC und in die beiden ausgelesenen Referenzzellen RC, RC'. Dabei schreibt der erste Leseverstärker SA0 Informationen gleichzeitig in drei Zellen, nämlich die linke Speicherzelle MC auf der ersten Bitleitung BL0 und in die beiden Referenzzellen RC, RC', denen die Referenzwortleitungen RWL2 und RWL4 zugeordnet sind. Der zweite Leseverstärker SA1 schreibt lediglich in die mit der dritten Bitleitung BL1 verbundene, zuvor ausgelesene Speicherzelle MC die aus dieser ausgelesene und verstärkte Information zurück.

Auf die beschriebene Weise ist gewährleistet, daß nach Beendigung des Lesezugriffs in den über ein gemeinsames erstes Schaltelement S1 verbundenen Referenzzellen RC, RC' immer entgegengesetzte Potentiale gespeichert sind. Somit kann bei einem nachfolgenden, erneuten Lesezugriff die Erzeugung des Referenzpotentials wiederum auf die schon beschriebene Weise erfolgen.

Das in Figur 1 links dargestellte erste Schaltelement S1 und die erste Steuerleitung 10 sowie das mit dieser verbundene zweite Schaltelement S2 dienen auf äquivalente Weise zur Erzeugung des Referenzpotentials und zum Rückschreiben von Informationen in die anderen beiden Referenzzellen RC, RC', denen die erste Referenzwortleitung RWL1 und die dritte Referenzwortleitung RWL3 zugeordnet sind, wenn Speicherzellen MC ausgelesen werden sollen, die mit der zweiten Bitleitung bBL0 und der vierten Bitleitung bBL1 verbunden sind.

Abweichend von Figur 1 ist es auch möglich, daß die ersten Schaltelemente S1 nicht an den den Leseverstärkern SAi zugewandten Enden der Bitleitungen BLi, bBLi angeordnet sind, sondern an deren gegenüberliegenden Enden, an denen auch die Referenzzellen RC, RC' angeordnet sind. Die ersten Schaltelemente S1 können insbesondere auch die mit dem jeweiligen Auswahltransistor T verbundene Elektrode der Speicherkondensatoren C der mit der entsprechenden Bitleitung verbundenen Referenzzellen RC, RC' miteinander verbinden, anstatt, wie in Figur 1 gezeigt, direkt zwischen den entsprechenden Bitleitungen angeordnet zu sein.

Figur 2 zeigt eine Variante des in Figur 1 dargestellten Ausführungsbeispiels. Es stimmt mit diesem in Aufbau und Funktion weitestgehend überein, so daß im folgenden nur auf die Unterschiede zwischen Figur 2 und Figur 1 eingegangen wird. Der Unterschied besteht hauptsächlich darin, daß die-beiden zweiten Schaltelemente S2 an ihren Steueranschlüssen mit einer gemeinsamen Steuerleitung 12 verbunden sind, so daß sie nur gleichzeitig leitend geschaltet oder gesperrt werden können.

Der erste Teil eines Lesezugriffs beim in Figur 2 dargestellten Speicher erfolgt genauso wie bei demjenigen aus Figur 1. Unterschiede bestehen lediglich im zweiten Teil eines Lesezugriffs, nämlich beim Rückschreiben von Informationen in die Referenzzellen. Beim Speicher gemäß Figur 2 erfolgt nämlich unabhängig davon, auf welche Speicherzellen MC zuvor zugegriffen worden ist, ein Rückschreiben von Information gleichzeitig in alle vier Referenzzellen RC, RC'. Hierzu sind während des Rückschreibens neben der jeweiligen Wortleitung WLi immer gleichzeitig die zweite Referenzwortleitung RWL2, die dritte Referenzwortleitung RWL3 und die Steuerleitung 12 auf einem hohen Pegel, während die erste Referenzwortleitung RWL1 und die vierte Referenzwortleitung RWL4 einen niedrigen Pegel aufweisen. Dies hat zur Folge, daß die beiden Anschlüsse des ersten Leseverstärkers SA0 mit der der vierten Referenzwortleitung RWL4 zugeordneten Referenzzelle RC' und mit der der zweiten Referenzwortleitung RWL2 zugeordneten Referenzzelle RC verbunden sind und die Anschlüsse des zweiten Leseverstärkers SA1 mit der der dritten Referenzwortleitung RWL3 zugeordneten Referenzzelle RC und mit der der ersten Referenzwortleitung RWL1 zugeordneten Referenzzelle RC' verbunden sind.

Somit wird gleichzeitig die von jedem Leseverstärker verstärkte Information in die soeben ausgelesene Speicherzelle MC und in jeweils ein Paar der Referenzzellen RC, RC' geschrieben. Dabei werden in die beiden Zellen jedes dieser Referenzzellenpaare jeweils komplementäre Informationen beziehungsweise Pegel eingeschrieben. Somit sind am Ende eines Lesezugriffs in den Referenzzellen RC, RC', deren Bitleitungen über eines der ersten Schaltelemente S1 miteinander verbunden sind, zueinander komplementäre Pegel gespeichert.

Das in Figur 2 dargestellte Ausführungsbeispiel hat gegenüber demjenigen aus Figur 1 den Vorteil, daß nur eine Steuerleitung 12 anstelle von zwei Steuerleitungen 10 und 11 benötigt werden und daß das Rückschreiben in die Referenzzellen RC, RC', unabhängig von der Position der jeweils auszulesenden Speicherzellen MC, immer auf die gleiche Weise geschieht. Dafür muß beim Rückschreiben auf alle vier Referenzzellen zugegriffen werden, obwohl für das eigentliche Auslesen nur jeweils zwei von ihnen benötigt werden.

## Patentansprüche

1. Integrierter Speicher
- mit Wortleitungen (WLi), vier Referenzwortleitungen (RWLi) und zwei Paaren von Bitleitungen (BLi, bBLi),
- mit Speicherzellen (MC), die in Kreuzungspunkten jeder Wortleitung (WLi) mit je einer Bitleitung (BLi, bBLi) jedes Paares angeordnet sind,
- mit Referenzzellen (RC, RC'), die in Kreuzungspunkten jeder Referenzwortleitung (RWLi) mit einer der Bitleitungen (BLi, bBLi) angeordnet sind,
- mit zwei differentiellen Leseverstärkern (SAi), die mit je einem der Bitleitungspaare verbunden sind,
- mit zwei ersten Schaltelementen (S1), die jeweils eine Bitleitung (BL0, bBL0) des ersten Paares mit einer Bitleitung (BL1, bBL1) des zweiten Paares verbinden,
- und mit zwei zweiten Schaltelementen (S2), die jeweils eine der Referenzzellen (RC') des einen Bitleitungspaares (BL0, bBL0) mit derjenigen Bitleitung (BL1, bBL1) des anderen Paares verbinden, die nicht über das entsprechende erste Schaltelement (S1) mit der dieser Referenzzelle (RC') zugeordneten Bitleitung verbunden ist.

2. Integrierter Speicher nach Anspruch 1,
- dessen Referenzzellen (RC, RC') ein Auswahlschaltelement (T) aufweisen, dessen Steueranschluß mit der entsprechenden Referenzwortleitung (RWLi) und dessen erster Anschluß seiner steuerbaren Strecke mit der entsprechenden Bitleitung (BLi, bBLi) verbunden ist,
- und bei dem bei denjenigen beiden Referenzzellen (RC'), die über die zweiten Schaltelemente (S2) mit einer Bitleitung des anderen Paares verbunden sind, der zweite Anschluß der steuerbaren Strecke ihres Auswahlschaltelements (T) mit dem entsprechenden zweiten Schaltelement (S2) verbunden ist.

3. Integrierter Speicher nach Anspruch 1,
dessen zweite Schaltelemente (S2) Steueranschlüsse aufweisen, die mit jeweils unterschiedlichen Steuerleitungen (10, 11) verbunden sind.

4. Integrierter Speicher nach Anspruch 1,
dessen zweite Schaltelemente (S2) Steueranschlüsse aufweisen, die mit einer gemeinsamen Steuerleitung (12) verbunden sind.

5. Betriebsverfahren für einen integrierten Speicher, der zwei Paare von Bitleitungen (BLi, bBLi) aufweist, die mit je einem differentiellen Leseverstärker (SAi) verbunden sind, sowie Speicherzellen (MC) und Referenzzellen (RC, RC'),
mit folgenden Schritten:
- Auslesen je einer der Referenzzellen (RC, RC') auf eine der Bitleitungen (BL0, BL1) jedes Paares,
- Kurzschließen dieser beiden Bitleitungen (BL0, BL1),
- Auslesen je einer Speicherzelle (MC) auf die beiden anderen Bitleitungen (bBL0, bBL1),
- Verstärken von sich auf den Bitleitungen einstellenden Differenzsignalen durch die Leseverstärker (SAi),
- Abkoppeln einer der beiden ausgelesenen Referenzzellen (RC') vom mit deren Bitleitung verbundenen Leseverstärker (SAi),
- Verbinden dieser abgekoppelten Referenzzelle (RC') mit derjenigen Bitleitung des anderen Paares, die zuvor nicht mit der dieser Referenzzelle zugeordneten Bitleitung kurzgeschlossen wurde,
- und gleichzeitiges Rückschreiben
- des von dem einen Leseverstärker (SAi) verstärkten Differenzsignals in eine der ausgelesenen Speicherzellen (MC) und in die beiden ausgelesenen Referenzzellen (RC)
- und des von dem anderen Leseverstärker verstärkten Differenzsignals in die andere ausgelesene Speicherzelle.

## Claims

1. Integrated memory
- having word lines (WLi), four reference word lines (RWLi) and two pairs of bit lines (BLi, bBLi),
- having memory cells (MC), which are arranged at crossover points of each word line (WLi) with a respective bit line (BLi, bBLi) of each pair,
- having reference cells (RC, RC'), which are arranged at crossover points of each reference word line (RWLi) with one of the bit lines (BLi, bBLi),
- having two differential sense amplifiers (SAi), which are connected to a respective one of the bit line pairs,
- having two first switching elements (S1), which respectively connect a bit line (BL0, bBL0) of the first pair to a bit line (BL1, bBL1) of the second pair,
- and having two second switching elements (S2), which respectively connect one of the reference cells (RC') of one bit line pair (BL0, bBL0) to that bit line (BL1, bBL1) of the other pair which is not connected via the corresponding first switching element (S1) to the bit line assigned to this reference cell (RC').

2. Integrated memory according to Claim 1,
- whose reference cells (RC, RC') have a selection switching element (T), whose control terminal is connected to the corresponding reference word line (RWLi) and whose first terminal of its controllable path is connected to the corresponding bit line (BLi, bBLi),
- and in which, in those two reference cells (RC') which are connected via the second switching elements (S2) to a bit line of the other pair, the second terminal of the controllable path of their selection switching element (T) is connected to the corresponding second switching element (S2).

3. Integrated memory according to Claim 1,
whose second switching elements (S2) have control terminals connected to different control lines (10, 11) in each case.

4. Integrated memory according to Claim 1,
whose second switching elements (S2) have control terminals connected to a common control line (12).

5. Operating method for an integrated memory having two pairs of bit lines (BLi, bBLi) which are connected to a respective differential sense amplifier (SAi), and also memory cells (MC) and reference cells (RC, RC'), having the following steps:
- read-out of a respective one of the reference cells (RC, RC') onto one of the bit lines (BL0, BL1) of each pair,
- short-circuiting of these two bit lines (BL0, BL1),
- read-out of a respective memory cell (MC) onto the two other bit lines (bBL0, bBL1),
- amplification of differential signals established on the bit lines by the sense amplifiers (SAi),
- decoupling of one of the two read-out reference cells (RC') from the sense amplifier (SAi) connected to the bit line thereof,
- connection of this decoupled reference cell (RC') to that bit line of the other pair which previously was not short-circuited with the bit line assigned to this reference cell,
- and simultaneous writing-back
- of the differential signal amplified by one sense amplifier (SAi) to one of the read-out memory cells (MC) and to the two read-out reference cells (RC)
- and of the differential signal amplified by the other sense amplifier to the other read-out memory cell.

## Revendications

1. Mémoire intégrée
- comprenant des lignes (WLi) de mots, quatre lignes (RWLi) de mots de référence et deux paires de lignes (BLi, bBLi) de bits,
- comprenant des cellules (MC) de mémoire qui sont disposées aux points d'intersection de chaque ligne (WLi) de mots avec respectivement une ligne (BLi, bBLi) de bits de chaque paire,
- comprenant des cellules (RC, RC') de référence qui sont disposées aux points d'intersection de chaque ligne (RWLi) de mots de référence avec l'une des lignes (BLi, bBLi) de bits,
- comprenant deux amplificateurs (SAi) différentiels de lecture qui sont reliés à respectivement l'une des paires de lignes de bits,
- comprenant deux premiers éléments (S1) de commutation qui relient respectivement une ligne (BL0, bBL0) de bits de la première paire à une ligne (BL1, bBL1) de bits de la deuxième paire,
- et comprenant deux deuxièmes éléments (S2) de commutation qui relient respectivement l'une des cellules (RC') de référence de l'une des paires (BLD, bBL0) de lignes de bits à la ligne (BL1, bBL1) de bits de l'autre paire, qui n'est pas reliée par le premier élément (S1) de commutation correspondant à la ligne de bits associée à cette cellule (RC') de référence.

2. Mémoire intégrée suivant la revendication 1,
- dont les cellules (RC, RC') de référence ont un élément (T) de commutation de sélection dont la borne de commande est reliée à la ligne (RWLi) de mots de référence correspondante et dont la première home de sa section qui peut être commandée est reliée à la ligne (BLi, bBLi) de bits correspondante,
- et dans laquelle, parmi les deux cellules (RC') de référence qui sont reliées parmi les deuxièmes éléments (S2) de commutation à une ligne de bits de l'autre paire, la deuxième borne de la section qui peut être commandée de son élément (T) de commutation de sélection est reliée au deuxième élément (S2) de commutation correspondant.

3. Mémoire intégrée suivant la revendication 1,
dont les deuxièmes éléments (S2) de commutation ont des bornes de commande qui sont reliées à, respectivement, des lignes (10, 11) différentes de commande.

4. Mémoire intégrée suivant la revendication 1,
dont les deuxièmes éléments (S2) de commutation ont des homes de commande qui sont reliées à une ligne (12) commune de commande.

5. Procédé pour faire fonctionner une mémoire intégrée qui a deux paires de lignes (BLi, bBLi) de bits qui sont reliées à, respectivement, un amplificateur (SAi) différentiel de lecture, ainsi que des cellules (MC) de mémoire et des cellules (RC, RC') de référence, comprenant les stades suivants :
- lecture de respectivement l'une des cellules (RC, RC') de référence sur l'une des lignes (BL0, BL1) de bits de chaque paire,
- court-circuitage de ces deux lignes (BL0, BL1) de bits,
- lecture de, respectivement, l'une des cellules (MC) de mémoire sur les deux autres lignes (bBL0, BL1) de bits,
- amplification de signaux de différence s'établissant sur les lignes de bits par les amplificateurs (SAi) de lecture,
- découplage de l'une des deux cellules (RC') de référence qui ont été lues, de l'amplificateur (SAi) de lecture relié à sa ligne de bits,
- liaison de cette cellule (RC') de référence découplée à la ligne de bits de l'autre paire qui n'a pas été auparavant court-circuitée par la ligne de bits associée à cette cellule de référence,
- et réécriture simultanée
- du signal de différence amplifié par ledit un amplificateur (SAi) de lecture dans l'une des cellules (MC) de mémoire qui ont été lues et dans les deux cellules (RC) de référence qui ont été lues,
- et du signal de différence amplifié par l'autre amplificateur de lecture dans l'autre cellule de mémoire qui a été lue.
